# EUROPEAN PATENT SPECIFICATION

(11) **EP 3 840 555 B1**
(45) Date of publication and mention of the grant of the patent: **09.07.2025**
(21) Application number: 19000580.1
(22) Date of filing: 20.12.2019
(51) Int. Cl.: H05K 7/20, G02F 1/1333, G02F 1/13357

(54) **DISPLAY DEVICE AND HEAT EXCHANGER THEREOF**
ANZEIGEVORRICHTUNG UND WÄRMETAUSCHER DAFÜR
DISPOSITIF D'AFFICHAGE ET ÉCHANGEUR DE CHALEUR CORRESPONDANT

(43) Date of publication of application: 23.06.2021
(73) Proprietor: Dynascan Technology Corp., Taoyuan City, 33383 (TW)
(72) Inventor: Wang, Tsun-I, 33383 Taoyuan City (TW); WU, Ching-Chun, 33383 Taoyuan City (TW); Yang, Chia-Liang, 33383 Taoyuan City (TW)
(74) Representative: Zacco GmbH

(56) References cited:
- EP-A2- 1 647 766
- US-A1- 2011 013 114
- US-A1- 2011 085 301
- US-A1- 2018 088 368

## Description

### BACKGROUND

### 1. Technical Field

The present disclosure provides a heat exchanger and a display device, more particularly to a heat exchanger with high heat dissipation efficiency and a display device using the heat exchanger for heat dissipation.

### 2. Related Art

With the development of technology, the demand for display devices is gradually increasing. In recent years, different types of display devices have been used, such as liquid crystal displays (LCDs), plasma display panels (PDPs), organic light emitting display (OLED) and the like. The light source module inside the display device is mainly to provide illumination of the display device.

Taking a liquid crystal display as an example, it generally includes a liquid crystal cell, a backlight module and a casing. A light source of the backlight module could be a line source or a point source, and light emitted by the source is converted into a high brightness and uniform surface light when passing through a light guide plate. Heat generated by the light source of the backlight module is transferred toward the casing of the liquid crystal display and then accumulated inside the casing.

US patent publication US 2011/0085301 A1 is directed to a heat exchanger for back to back electronic displays. A cooling assembly for a dual electronic image assembly having two gas pathways. The first gas pathway allows circulating gas to travel across the front surface of a pair of electronic image assemblies and through a heat exchanger. The second gas pathway allows ambient gas to pass through the heat exchanger and extract heat from the circulating gas. The first and second gas pathways are connected. A fan assembly is placed so that the circulating gas will be forced through the first gas pathway.

US patent publication US 2018/0088368 A1 is directed to a liquid crystal display device. The liquid crystal display device includes: a liquid crystal cell, an optical sheet, and a backlight disposed; a heat absorber; and a heat sink. The heat absorber is disposed in an airtight circulation channel and cools a coolant that circulates in the airtight circulation channel so as to pass through a first channel between the liquid crystal cell and the optical sheet and a second channel between the optical sheet and the backlight. The heat sink is thermally coupled to the heat absorber and exposed to ambient air. The backlight is between the heat absorber and the heat sink. The heat absorber and the heat sink are separate elements.

### SUMMARY

According to one aspect of the disclosure, a heat exchanger for an electronic device including a light module is provided. The heat exchanger includes: an internal heat exchange portion; an external heat exchange portion; and a flow generator. The internal heat exchange portion is configured to be adjacently attached to the light module. The internal heat exchange portion includes at least one internal heat dissipation channel. The internal heat dissipation channel is connected with a device space of the electronic device. A high temperature gas flow generated by the electronic device is enabled to pass through the device space and the internal heat dissipation channel. The external heat exchange portion is in thermal contact with the internal heat exchange portion. The external heat exchange portion includes an external heat dissipation structure. The external heat dissipation structure is non-connected with the at least one internal heat dissipation channel. The at least one internal heat dissipation channel is provided between the external heat dissipation structure and the light module. The flow generator corresponds to the external heat exchange portion. An ambient air flow is enabled to pass through the external heat dissipation structure.

In one embodiment of the disclosure, the external heat dissipation structure includes at least one external heat dissipation channel, and the ambient air flow is enabled to pass through the external heat dissipation channel.

In one embodiment of the disclosure, the external heat dissipation structure includes a plurality of heat sink fins, and the ambient air flow is enabled to pass through the heat sink fins.

In one embodiment of the disclosure, the internal heat exchange portion includes an inner side surface facing toward the light module, and the external heat exchange portion includes an outer side surface opposite to the inner side surface. The internal heat dissipation channel and the at least one external heat dissipation channel are located between the inner side surface and the outer side surface.

In one embodiment of the disclosure, both a number of the at least one internal heat dissipation channel and a number of the at least one external heat dissipation channel are multiple.

In one embodiment of the disclosure, a sum of cross sectional areas of the internal heat dissipation channels and the external heat dissipation channels is 35% to 70% of a sum of cross sectional areas of the internal heat exchange portion and the external heat exchange portion.

In one embodiment of the disclosure, the heat exchanger includes a plurality of heat sink fins disposed in at least one of the internal heat dissipation channel and the external heat dissipation channel.

In one embodiment of the disclosure, the electronic device include a display device, and the light module includes a backlight module of the display device. A display device includes: casing, a cover, a display assembly, a first flow generator, the flow generator, and the heat exchanger. The casing includes a display portion and a rear portion opposite to each other. The cover is disposed on the casing. The display assembly includes a display unit and the backlight module. The display unit is exposed to outside by the display portion. The first flow generator is disposed in the casing. The flow generator is disposed on the cover. The heat exchanger is disposed on the rear portion of the casing. The internal heat exchange portion is configured to be adjacently attached to the backlight module of the display assembly. The backlight module is in thermal contact with the internal heat exchange portion. The at least one internal heat dissipation channel is connected with an assembly space of the display assembly. The first flow generator corresponds to the at least one internal heat dissipation channel. the high temperature gas flow generated by the display assembly is enabled to pass through the assembly space and the at least one internal heat dissipation channel.

In one embodiment of the disclosure, the display assembly further includes a chamber. The chamber is located between the display unit and the backlight module, and the chamber has the assembly space.

### BRIEF DESCRIPTION OF THE DRAWINGS

The present disclosure will become more understood from the detailed description given hereinbelow and the accompanying drawings which are given by way of illustration only and thus are not limitative of the present disclosure and wherein:
FIG. 1A through FIG. 1D are schematic views of an electronic device including a light module and a heat exchanger according to an embodiment of the present disclosure;
FIG. 2 is a perspective view of a display device according to a first embodiment of the present disclosure;
FIG. 3 is an exploded view of the display device in FIG. 2;
FIG. 4 is a perspective view of a heat exchanger of the display device in FIG. 3;
FIG. 5 is a cross sectional view of the heat exchanger in FIG. 4 along line A-A;
FIG. 6 is a cross sectional view of the display device in FIG. 2;
FIG. 7 is a cross sectional view of a display device according to a second embodiment of the present disclosure;
FIG. 8 is a cross sectional view of a heat exchanger for display device according to a third embodiment of the present disclosure;
FIG. 9 is a cross sectional view of a heat exchanger for display device according to a fourth embodiment of the present disclosure;
FIG. 10 is an exploded view of the display device according to a fifth embodiment of the present disclosure; and
FIG. 11 is a cross sectional view of the display device in FIG. 10.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawings.

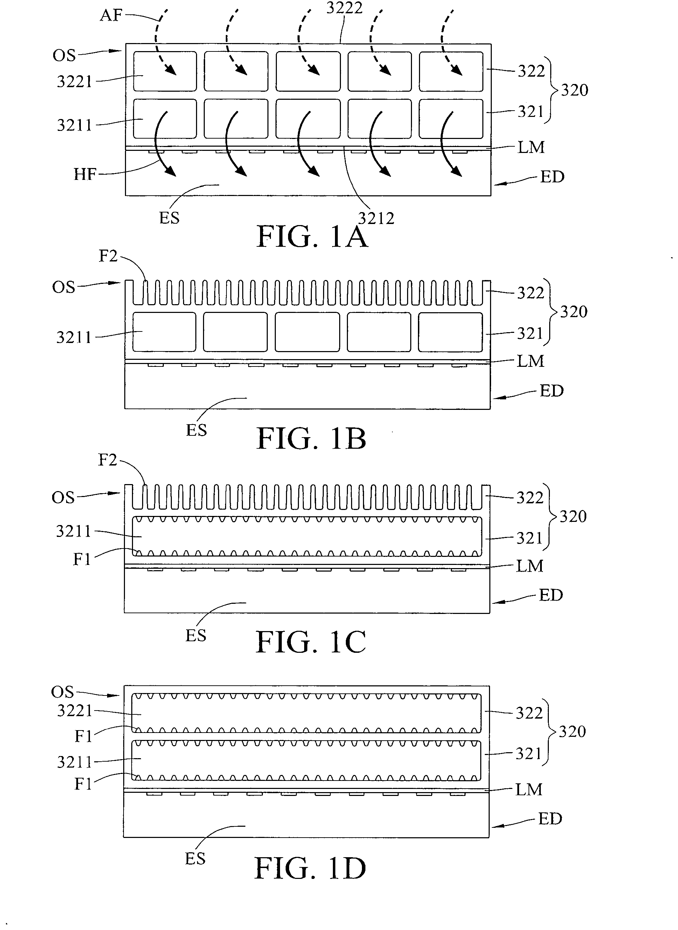

Please refer to FIG. 1A to FIG. 1D. FIG. 1A through FIG. 1D are schematic views of an electronic device including a light module and a heat exchanger according to an embodiment of the present disclosure. A heat exchanger 320 is able to be adjacently attached to a light module LM of an electronic device ED for improving the heat dissipation of the electronic device ED, and the electronic device ED may be a display device or an illumination device. Under a condition that the electronic device ED is a display device, the light module LM is a backlight module; and under a condition that the electronic device ED is an illumination device, the light module LM is a lighting source.

Further, the heat exchanger 320 includes an internal heat exchange portion 321 and an external heat exchange portion 322.

The internal heat exchange portion 321 is configured to be adjacently attached to a rear surface of the light module LM (that is, a surface far away from a luminous surface), and the internal heat exchange portion 321 has at least one internal heat dissipation channel 3211. The at least one internal heat dissipation channel 3211 is connected with a device space ES of the electronic device ED; that is, a high temperature gas flow HF generated by the electronic device ED is enabled to pass through the device space ES and the at least one internal heat dissipation channel 3211. Moreover, the number of the internal heat dissipation channel 3211 may be one or more than one, and multiple heat sink fins F1 may be disposed in the at least one internal heat dissipation channel 3211.

The external heat exchange portion 322 is in thermal contact with the internal heat exchange portion 321. The external heat exchange portion 322 has an external heat dissipation structure OS non-connected with the at least one internal heat dissipation channel 3211; that is, the gas flow (for example, the high temperature gas flow HF) passing through the at least one heat dissipation channel 3211 does not flow into the external heat dissipation structure OS, and the gas flow (for example, an ambient air flow) passing through the external heat dissipation structure OS does not flow into the at least one internal heat dissipation channel 3211. In one embodiment, the external heat dissipation structure OS has at least one external heat dissipation channel 3221 non-connected with the at least one heat dissipation channel 3211. In another embodiment, the external heat dissipation structure OS has at least one external heat dissipation channel 3221 in which multiple heat sink fins F1 are disposed. In still another embodiment, the external heat dissipation structure OS includes multiple heat sink fins F2.

Various aspects of the heat exchanger 320 are illustrated in the following paragraphs.

As shown in FIG. 1A, the number of the internal heat dissipation channel 3211 is multiple (take five internal heat dissipation channels as example). The external heat dissipation structure OS has at least one external heat dissipation channel 3221, and the number of the external heat dissipation channel 3221 is five as an exemplary illustration. The internal heat exchange portion 321 has an inner side surface 3212 facing toward the light module LM. The external heat exchange portion 322 has an outer side surface 3222 opposite to the inner side surface 3212. Both the at least one internal heat dissipation channel 3211 and the at least one external heat dissipation channel 3221 are located between the inner side surface 3212 and the outer side surface 3222.

As shown in FIG. 1B, the number of the internal heat dissipation channel 3211 is five as an exemplary illustration. The external heat dissipation structure OS includes multiple heat sink fins F2.

As shown in FIG. 1C, the number of the internal heat dissipation channel 3211 is one as an exemplary illustration. The heat exchanger 320 further includes multiple heat sink fins F1 disposed in the internal heat dissipation channel 3211, and the external heat dissipation structure OS includes multiple heat sink fins F2.

As shown in FIG. 1D, the number of the internal heat dissipation channel 3211 is one as an exemplary illustration. The heat exchanger 320 further includes multiple heat sink fins F1 disposed in the internal heat dissipation channel 3211, and the external heat dissipation structure OS has at least one external heat dissipation channel 3221. In this embodiment, the number of the external heat dissipation channel 3221 is one as an exemplary illustration. The heat exchanger 320 further includes multiple heat sink fins F1 disposed in the external heat dissipation channel 3221.

It is noted that the heat exchangers 320 shown in FIG. 1A through FIG. 1D are exemplary, and the present disclosure is not limited to the configuration of the heat exchangers 320.

In order to describe the heat dissipation mechanism of the heat exchanger 320 more specifically, the heat exchanger 320 is applied to a display device for example. In the following paragraphs, both the number of internal heat dissipation channel 3211 of the internal heat exchange portion 321 and the number of external heat dissipation structure OS of the external heat exchange portion 322 are multiple as exemplary illustration.

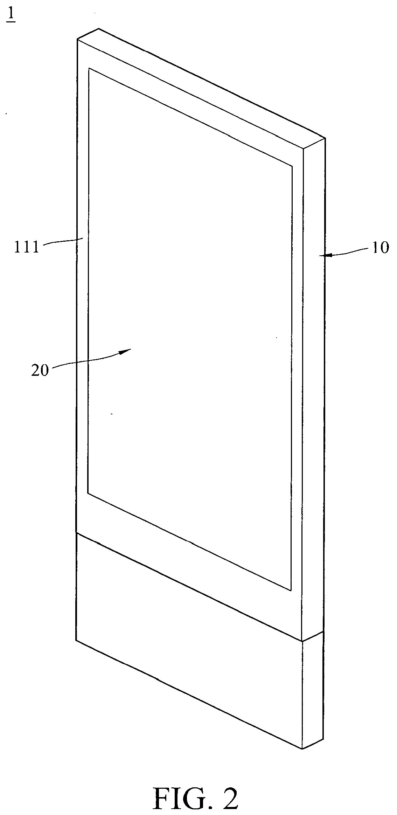

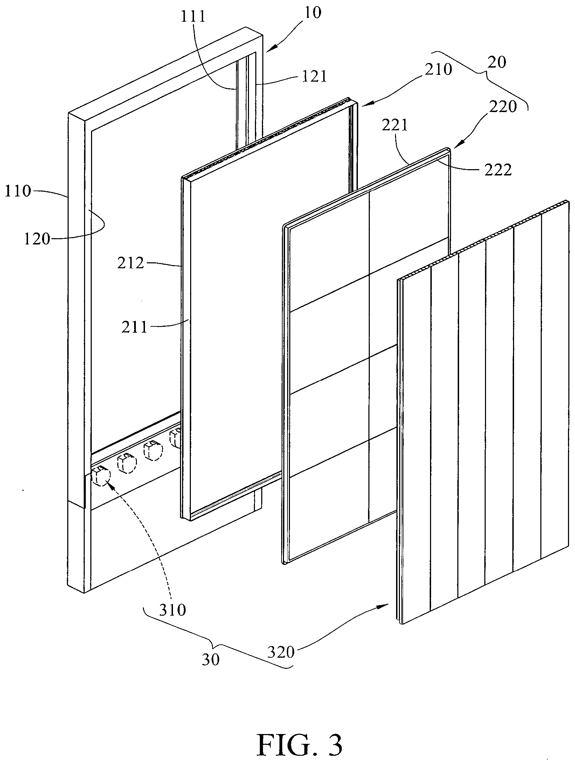

Please refer to FIG. 2 and FIG. 3. FIG. 2 is a perspective view of a display device according to a first embodiment of the present disclosure. FIG. 3 is an exploded view of the display device in FIG. 2. In this embodiment, a display device 1 includes a casing 10, a display assembly 20 and a heat exchanger 320. In this embodiment, the display device 1 is a direct LED.

The casing 10 includes a display portion 110 and a rear portion 120 opposite to each other. The display portion 110 has a displaying opening 111, and the rear portion 120 has a mounting opening 121. The casing 10 further has an accommodation space 130 connected with the displaying opening 111 and the mounting opening 121.

The display assembly 20 is disposed in the accommodation space 130 of the casing 10. The display assembly 20 includes a display unit 210 and a backlight module 220. The display unit 210 includes a liquid cell layer 211 and a cover glass 212. The cover glass 212 is disposed in the displaying opening 111 of the display portion 110 of the casing 10, and the liquid cell layer 211 is exposed to outside by the displaying opening 111. The backlight module 220 includes an optical film 221 and a light source 222, and the optical film 221 may include diffuser film, brightness enhancement film or the like. Moreover, the display assembly 20 further includes a chamber 230 between the display unit 210 and the backlight module 220, and the chamber 230 has an assembly space 231. The assembly space 231 is connected with the accommodation space 130 of the casing 10.

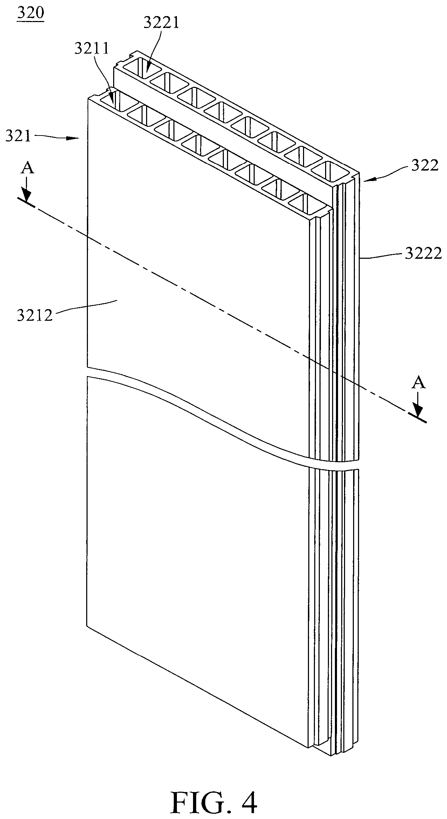

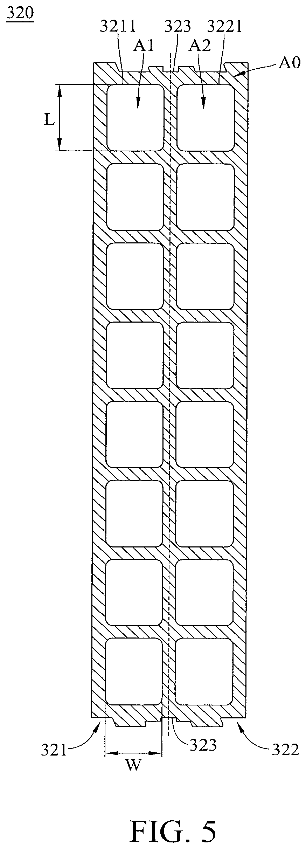

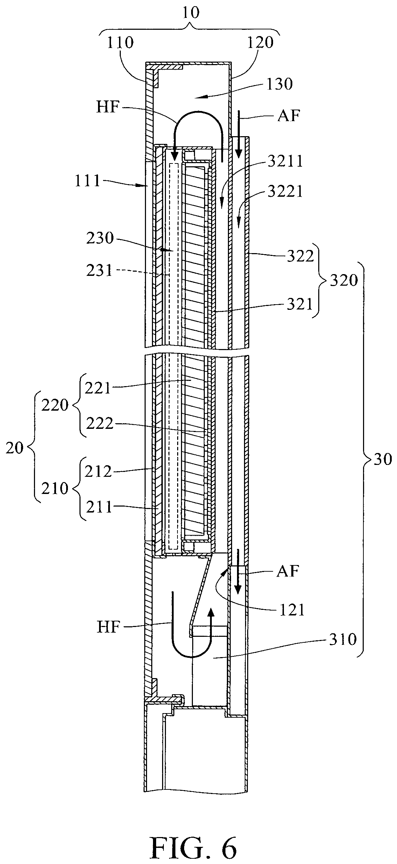

The heat exchanger 320 is disposed on the casing 10. Please further refer to FIG. 4 through FIG. 6. FIG. 4 is a perspective view of a heat exchanger of the display device in FIG. 3. FIG. 5 is a cross sectional view of the heat exchanger in FIG. 4 along line A-A. FIG. 6 is a cross sectional view of the display device in FIG. 2.

The display device 1 further includes multiple flow generators 310. The flow generators 310, for example, are fans disposed in the accommodation space 130 of the casing 10 and configured to generate gas flow in the accommodation space 130. It is worth noting that the number of the flow generator 310 is not limited in view of embodiments in the present disclosure.

The heat exchanger 320, for example, is a metal plate made of aluminum. The heat exchanger 320 includes an internal heat exchange portion 321 and an external heat exchange portion 322 which are connected and in thermal contact with each other. The internal heat exchange portion 321 has multiple internal heat dissipation channels 3211, and the external heat exchange portion 322 has multiple external heat dissipation channels 3221. The internal heat dissipation channels 3211 of the internal heat exchange portion 321 are non-connected with the external heat dissipation channels 3221 of the external heat exchange portion 322; in other words, in view of a cross section A0 of the heat exchanger 320 (a cross section of the heat exchanger 320 along line A-A in FIG. 4), the internal heat dissipation channels 3211 are spaced apart from the external heat dissipation channels 3221, such that any gas in the internal heat dissipation channels 3211 is unable to flow into the external heat dissipation channels 3221. The internal heat exchange portion 321 further has an inner side surface 3212 facing toward the display assembly 20, and the external heat exchange portion 322 further has an outer side surface 3222 opposite to the inner side surface 3212. Both the internal heat dissipation channel 3211 and the external heat dissipation channel 3221 are located between the inner side surface 3212 and the outer side surface 3222. It is worth noting that numbers of the internal heat dissipation channel 3211 and the external heat dissipation channel 3221 are not limited in view of embodiments in the present disclosure.

The heat exchanger 320 is disposed in the mounting opening 121 of the rear portion 120 of the casing 10. In detail, the heat exchanger 320 further includes an assembling structure 323 located between the internal heat exchange portion 321 and the external heat exchange portion 322. As shown in FIG. 5, the internal heat dissipation channel 3211 and the external heat dissipation channel 3221 are arranged at opposite two sides of a reference line, respectively, and the reference line passes across the assembling structure 323. In this embodiment, the assembling structure 323 is groove in which a seal ring (not shown in the drawings) may be accommodated, and the heat exchanger 320 is mounted in the mounting opening 121 by the interference fit between the seal ring and edge of the mounting opening 121. In another embodiment, the heat exchanger is adhered to the mounting opening by adhesive stuffed in the assembling structure. In yet another embodiment, the assembling structure is a hook corresponding to a slot formed on edge of the mounting opening.

The internal heat exchange portion 321 is disposed in the accommodation space 130, and the light source 222 of the backlight module 220 of the display assembly 20 is adjacently attached to the inner side surface 3212 of the internal heat exchange portion 321 so as to be in thermal contact with the internal heat exchange portion 321. In other words, the backlight module 220 is disposed between the display unit 210 and the heat exchanger 320. The internal heat dissipation channels 3211 are connected with the accommodation space 130, such that the gas flow generated by the flow generators 310 in the casing 10 is enabled to pass through the internal heat dissipation channels 3211. The external heat exchange portion 322 protrudes out of the rear portion 120 from the mounting opening 121, and the external heat dissipation channels 3221 are connected with outside. In this embodiment, since the casing 10 insulates the internal heat dissipation channels 3211 from outside and a non-connection is provided between the internal heat dissipation channels 3211 and the external heat dissipation channels 3221, the ambient air flow AF is unable to flow into the internal heat dissipation channels 3211, and the gas flow in the casing 10 is unable to flow into the external heat dissipation channels 3221.

The heat exchanger 320 according to this embodiment is favorable for dissipating heat from the display assembly 20 so as to reduce the temperature of the display assembly 20. Heat accumulated in the display assembly 20 mainly comes from two ways; one way is heat generated by the display assembly 20 under sunlight exposure, and the other way is heat generated by the light source 222 of the backlight module 220. As shown in FIG. 6, the flow generators 310 generate gas flow in the accommodation space 130 of the casing 10 in order to bring heat generated by the display assembly 20 away from the backlight module 220 via the chamber 230, wherein the chamber 230 is located between the display unit 210 and the backlight module 220, especially between the liquid cell of the display unit 210 and the optical film 221 of the backlight module 220. In detail, heat generated by the sunlight incident on the display unit 210 transferred to the chamber 230. By a characteristic of heat transfer from high temperature to low temperature during heat exchange or force of the flow generators 310, the high temperature gas flow HF moves from the chamber 230 to the internal heat dissipation channels 3211 of the internal heat exchange portion 321 through the accommodation space 130, thereby achieving circulating flow. Due to the connection between the internal heat dissipation channels 3211 and the inside of the display assembly 20, the high temperature gas flow HF caused by sunlight flows among the chamber 230 of the display assembly 20 and the internal heat dissipation channels 3211.

The ambient air AF (such as cold air) flows in the external heat dissipation channels 3221 of the external heat exchange portion 322. The high temperature gas flow HF in the internal heat dissipation channels 3211 raises the temperature of the internal heat exchange portion 321, and the ambient air flow AF in the external heat dissipation channels 3221 reduces the temperature of the external heat exchange portion 322. Therefore, due to the thermal contact between the internal heat exchange portion 321 and the external heat exchange portion 322, heat generated by the display unit 210 and the backlight module 220 of the display assembly 20 is transferred to outside through the heat exchanger 320, thereby reduce the temperature of the display assembly 20.

It is noted that heat generated by the sunlight incident on the display assembly 20 or the light source 222 of the backlight module 220 is accumulated in the display assembly 20. The display assembly 20 may include a polarizer (not shown in the drawings), a color filter (not shown in the drawings), an alignment film (not shown in the drawings), the liquid cell layer 211, an optical film (not shown in the drawings) or the like. The heat exchanger 320 is mainly configured to dissipate heat accumulated in the component(s) of the display assembly 20.

In this embodiment, the heat exchanger 320 equipped with the flow generators 310 is used for heat dissipation of the display assembly 20 so as to reduce the temperature of the display assembly 20. However, a device which the heat exchanger 320 is applied to for heat dissipation is not limited in view of embodiments in the present disclosure.

Results of heat dissipation in the display device of the first embodiment and a conventional display device are illustrated in the following Table I. With a backlight module having same light source power and a casing made of same material, the conventional display device shows higher liquid crystal temperature than the display device disclosed in the first embodiment during operation, which indicates that the heat exchanger of the present disclosure helps to dissipate heat from the components of the display device.

| Table I | | |
|---|---|---|
| | Conventional display device | Display device of the first embodiment |
| Liquid crystal temperature(°C) | 95.4 | 70.7 |

As shown in FIG. 2 and FIG. 3, in this embodiment, the size of internal heat exchange portion 321 of the heat exchanger 320 matches the size of mounting opening 121, such that any gap between the heat exchanger 320 and edge of the mounting opening 121 is prevented. The heat exchanger 320 is disposed in the mounting opening 121, for example, in embedded manner or adhesive manner. Thus, with working with the non-connected design between the internal heat dissipation channel 3211 and the external heat dissipation channel 3221, it is favorable for preventing moisture and dust existed in the external environment from entering into the casing 10, and thus the display device 1 is suitable for outdoor use. In some other embodiments, both the sizes of internal heat exchange portion 321 and external heat exchange portion 322 can match the size of mounting opening 121.

Furthermore, in this embodiment, a cross sectional area A1 of each internal heat dissipation channel 3211 of the internal heat exchange portion 321 and a cross sectional area A2 of each external heat dissipation channel 3221 of the external heat exchange portion 322 are both rectangular. As shown in FIG. 5, in view of a cross section A0 of the heat exchanger 320, cross sections of each internal heat dissipation channel 3211 and each external heat dissipation channel 3221 are the aforementioned cross sectional areas. As to the cross sectional area A1 of each internal heat dissipation channel 3211 and the cross sectional area A2 of each external heat dissipation channel 3221, the aspect ratio (ratio of length to width) is from 1:1 to 3:1. In this embodiment, each of the cross sectional areas A1 and A2 is a rectangular cross section with length L equal to 18.5 millimeters (mm) and width W equal to 15 mm. Thus, it is favorable for preventing negative influence on the compactness of the display device 1 due to overly thick heat exchanger 320. It is worth noting that shapes of the cross sectional areas A1 and A2 are not limited in view of embodiments in the present disclosure.

Moreover, in this embodiment, the heat exchanger 320 is an integrated single piece. Thus, it is favorable for an easier manufacturing of the heat exchanger 320 so as to reduce cost and ensure a proper thermal contact between the internal heat exchange portion 321 and the external heat exchange portion 322. It is noted that an integrated heat exchanger 320 is not limited in view of embodiments in the present disclosure. In some other embodiments, the internal heat exchange portion and the external heat exchange portion are separated components which are assembled together to obtain the heat exchanger.

As shown in FIG. 5, a sum of cross sectional areas A1 of all internal heat dissipation channels 3211 and cross sectional areas A2 of all external heat dissipation channels 3221

(that is, the total of cross section areas A1 and cross sectional areas A2) is 35% to 70% of the cross section A0 of the heat exchanger 320 (that is, a sum of cross sectional area of the internal heat exchange portion 321 and cross sectional area of the external heat exchange portion 322). Preferably, a sum of cross sectional areas A1 and cross sectional areas A2 is 37% to 62% of the cross section A0. Thus, sizes of the internal heat dissipation channel 3211 and the external heat dissipation channel 3221 is proper for sufficient flow rate, and the heat dissipation area on inner walls inside the internal heat dissipation channel 3211 and the external heat dissipation channel 3221 is favorable for providing better thermal contact between the air flow and the heat exchanger 320. In FIG. 5, the sum of all cross sectional areas A1 and all cross sectional areas A2 (sum = (A1 X 8)+(A2 X 8)) is 62% of the cross section A0.

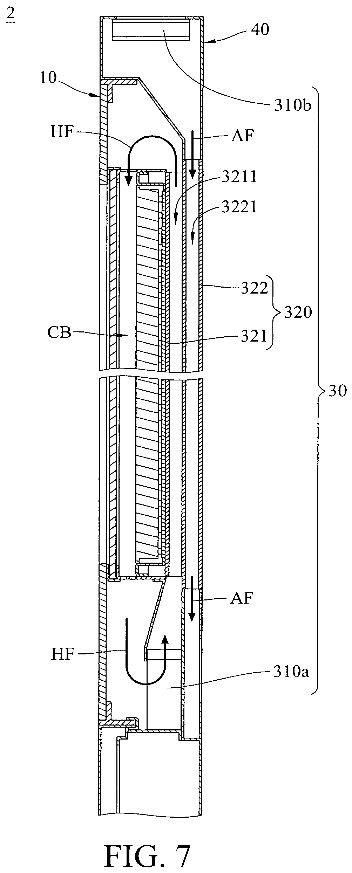

FIG. 7 is a cross sectional view of a display device according to a second embodiment of the present disclosure. Since the second embodiment is similar to the first embodiment, only differences will be described hereafter.

In this embodiment, a display device 2 further includes a cover 40 disposed on the casing 10, multiple first flow generators 310a (referred to the flow generators 310 in the first embodiment) and multiple second flow generators 310b. The first flow generators 310a are disposed in the casing 10. The second flow generators 310b is disposed on the cover 40, and the second flow generators 310b correspond to the external heat dissipation channels 3221 of the external heat exchange portion 322. The first flow generator 310a is configured to bring the high temperature gas flow HF in the casing 10 into the internal heat dissipation channels 3211 of the internal heat exchange portion 321. The second flow generator 310b is configured to bring ambient air flow AF into the external heat dissipation channels 3221 of the external heat exchange portion 322.

Since the second flow generator 310b forces air movement to create ambient air flow AF, it is favorable for enhancing heat exchange efficiency between the internal heat exchange portion 321 and the external heat exchange portion 322. Also, since the cover 40 covers the external heat exchange portion 322 protruding from the casing 10, it is favorable for an attractive appearance of the display device 2.

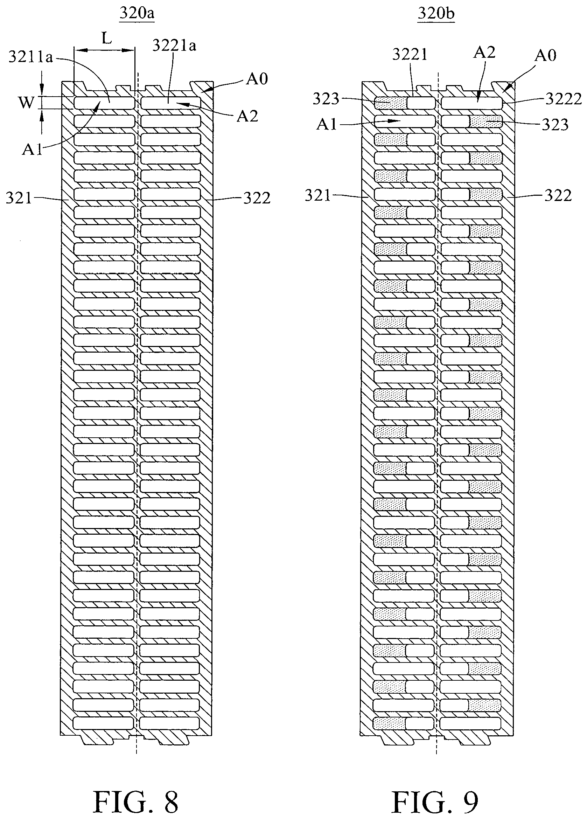

FIG. 8 is a cross sectional view of a heat exchanger for display device according to a third embodiment of the present disclosure. Since the third embodiment is similar to the first embodiment, only differences will be described hereafter.

In this embodiment, each internal heat dissipation channel 3211a and each external heat dissipation channel 3221a of the heat exchanger 320a has a rectangular cross sectional area with the length L equal to 35 mm and the width W equal to 7.5 mm. The sum of all cross sectional areas A1 and all cross sectional areas A2 is 58% of the cross section A0 of the heat exchanger 320a.

Results of heat dissipation in a display device including the heat exchanger of the third embodiment and the display device of the first embodiment are illustrated in the following Table II. The display device including the heat exchanger of the third embodiment shows higher liquid crystal temperature and higher light source temperature than the display device disclosed in the first embodiment during operation.

| Table II | | |
|---|---|---|
| | Display device of the first embodiment | Display device including heat exchanger of the third embodiment |
| Liquid crystal temperature(°C) | 70.7 | 82 |
| Light source temperature(°C) | 69 | 70 |

FIG. 9 is a cross sectional view of a heat exchanger for display device according to a fourth embodiment of the present disclosure. Since the fourth embodiment is similar to the first embodiment, only differences will be described hereafter.

In this embodiment, the heat exchanger 320b further includes multiple heat sink fins F1. The heat sink fins F1 are respectively disposed in some of the internal heat dissipation channels 3211 of the internal heat exchange portion 321 and some of the external heat dissipation channels 3221 of the external heat exchange portion 322. Thus, it is favorable for increasing the surface area for heat dissipation in the internal heat dissipation channels 3211 and the external heat dissipation channels 3221.

Furthermore, in this embodiment, the sum of all cross sectional areas A1 and all cross sectional areas A2 is 37% of the cross section A0 of the heat exchanger 320b.

Results of heat dissipation in a display device including the heat exchanger of the fourth embodiment and the display device of the first embodiment are illustrated in the following Table III. The display device including the heat exchanger of the fourth embodiment shows higher liquid crystal temperature and higher light source temperature than the display device disclosed in the first embodiment during operation.

| Table III | | |
|---|---|---|
| | Display device of the first embodiment | Display device including heat exchanger of the fourth embodiment |
| Liquid crystal temperature(°C) | 70.7 | 73.6 |
| Light source temperature(°C) | 69 | 72 |

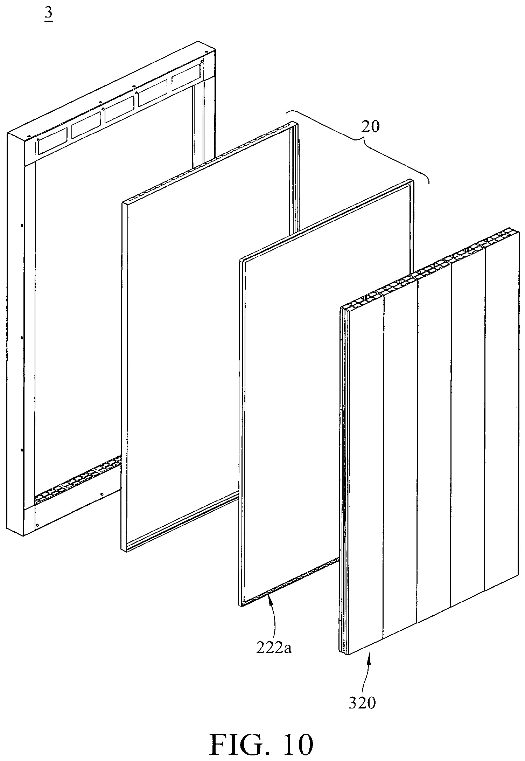

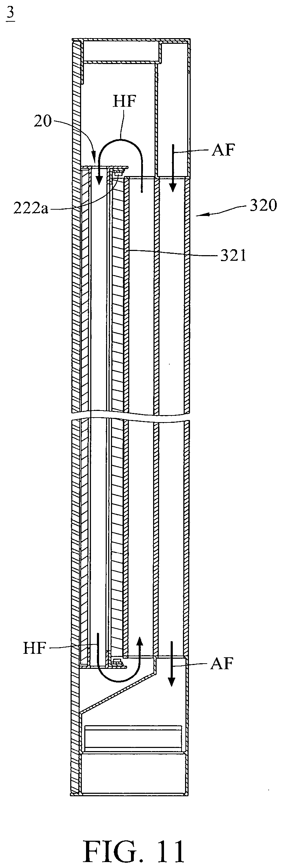

FIG. 10 is an exploded view of the display device according to a fifth embodiment of the present disclosure. FIG. 11 is a cross sectional view of the display device in FIG. 10. Since the fifth embodiment is similar to the first embodiment, only differences will be described hereafter.

In this embodiment, a display device 3 is an edge LED. In detail, the display assembly 20 of the display device 3 includes a light source 222a, and the light source 222a is positioned to be adjacent to the internal heat exchange portion 321 of the heat exchanger 320.

According to the disclosure, the heat exchanger includes the internal heat exchange portion and the external heat exchange portion. The flow generator brings the high temperature gas flow in the casing to the internal heat dissipation channel of the internal heat exchange portion. The ambient air flow in the external environment passes through the external heat dissipation channel of the external heat exchange portion. Due to heat exchange between the internal heat dissipation channel and the external heat dissipation channel, heat generated by the backlight module is transferred to outside via the heat exchanger, thereby reducing the temperature of the display device.

Moreover, the design of non-connection between the internal heat dissipation channel and the external heat dissipation channel is favorable for preventing moisture and dust existed in the external environment from entering into the casing, and thus the display device is suitable for outdoor use.

## Claims

1. A heat exchanger (320) for an electronic device (ED) comprising a light module (LM), the heat exchanger (320) **characterized in that** the heat exchanger (320) comprises:
an internal heat exchange portion (321) configured to be adjacently attached to the light module (LM), the internal heat exchange portion (321) including at least one internal heat dissipation channel (3211), the at least one internal heat dissipation channel (3211) being connected with a device space (ES) of the electronic device (ED), wherein a high temperature gas flow (HF) generated by the electronic device (ED) is enabled to pass through the device space (ES) and the at least one internal heat dissipation channel (3211);
an external heat exchange portion (322) in thermal contact with the internal heat exchange portion (321), the external heat exchange portion (322) including an external heat dissipation structure (OS) non-connected with the at least one internal heat dissipation channel (3211), wherein the at least one internal heat dissipation channel (3211) is provided between the external heat dissipation structure (OS) and the light module (LM); and
a flow generator (310b) corresponding to the external heat exchange portion (322),
wherein an ambient air flow (AF) is enabled to pass through the external heat dissipation structure (OS).

2. The heat exchanger according to claim 1, wherein the external heat dissipation structure (OS) includes at least one external heat dissipation channel (3221), and the ambient air flow (AF) is enabled to pass through the at least one external heat dissipation channel (3221).

3. The heat exchanger according to claim 1 or 2, wherein the external heat dissipation structure (OS) comprises a plurality of heat sink fins (F1), and the ambient air flow (AF) is enabled to pass through the plurality of heat sink fins (F1).

4. The heat exchanger according to claim 2 or 3, wherein the internal heat exchange portion (321) further includes an inner side surface (3212) facing toward the light module (LM), the external heat exchange portion (322) further includes an outer side surface (3222) opposite to the inner side surface (3212), the at least one internal heat dissipation channel (3211) and the at least one external heat dissipation channel (3221) are located between the inner side surface (3212) and the outer side surface (3222).

5. The heat exchanger according to any one of claims 2 to 4, wherein both a number of the at least one internal heat dissipation channel (3211) and a number of the at least one external heat dissipation channel (3221) are multiple, wherein a sum of cross sectional areas of the internal heat dissipation channels (3211) and the external heat dissipation channels (3221) is 35% to 70% of a sum of cross sectional areas of the internal heat exchange portion (321) and the external heat exchange portion (322).

6. The heat exchanger according to any one of claims 2 to 5, further comprising a plurality of heat sink fins (F1) disposed in at least one of the at least one internal heat dissipation channel (3211) and the at least one external heat dissipation channel.

7. The heat exchanger according to claim 1, wherein the electronic device (ED) includes a display device (1), the light module includes a backlight module (220) of the display device (1), wherein the display device (1) comprises:
a casing (10) comprising a display portion (110) and a rear portion (120) opposite to each other;
a cover (212) disposed on the casing (10); and
a display assembly (20) comprising a display unit (210) and the backlight module (220), wherein the display unit (210) is exposed to outside by the display portion (110);
a first flow generator (310a) disposed in the casing (10);
the flow generator (310b) disposed on the cover (212); and
the heat exchanger (320) disposed on the rear portion (120) of the casing (10),
the internal heat exchange portion (321) is configured to be adjacently attached to the backlight module (220) of the display assembly (20),
the backlight module (220) is in thermal contact with the internal heat exchange portion (321),
the at least one internal heat dissipation channel (3211) is connected with an assembly space (231) of the display assembly (20),
the first flow generator (310a) corresponds to the at least one internal heat dissipation channel (3211), and
the high temperature gas flow (HF) generated by the display assembly (20) is enabled to pass through the assembly space (20) and the at least one internal heat dissipation channel (3211).

8. The heat exchanger according to claim 7, wherein the internal heat exchange portion (321) further includes an inner side surface (3212) facing toward the display assembly (20).

9. The heat exchanger according to any one of claims 7 and 8, wherein the display assembly (20) further comprises a chamber (230), the chamber (230) is located between the display unit (210) and the backlight module (220), and the chamber (230) includes the assembly space (231).

## Patentansprüche

1. Wärmetauscher (320) für eine elektronische Vorrichtung (ED), umfassend ein Lichtmodul (LM), wobei der Wärmetauscher (320) **dadurch gekennzeichnet ist, dass** der Wärmetauscher (320) Folgendes umfasst:
einen inneren Wärmeaustauschabschnitt (321), der dazu konfiguriert ist, angrenzend an das Lichtmodul (LM) angebracht zu werden, wobei der innere Wärmeaustauschabschnitt (321) mindestens einen inneren Wärmeableitungskanal (3211) beinhaltet, wobei der mindestens eine innere Wärmeableitungskanal (3211) mit einem Vorrichtungsraum (ES) der elektronischen Vorrichtung (ED) verbunden ist, wobei ein Hochtemperaturgasstrom (HF), der durch die elektronische Vorrichtung (ED) erzeugt wird, in die Lage versetzt wird, durch den Vorrichtungsraum (ES) und den mindestens einen inneren Wärmeableitungskanal (3211) hindurch zu strömen;
einen äußeren Wärmeaustauschabschnitt (322) in thermischem Kontakt mit dem inneren Wärmeaustauschabschnitt (321), wobei der äußere Wärmeaustauschabschnitt (322) eine äußere Wärmeableitungsstruktur (OS) beinhaltet, die nicht mit dem mindestens einen inneren Wärmeableitungskanal (3211) verbunden ist, wobei der mindestens eine innere Wärmeableitungskanal (3211) zwischen der äußeren Wärmeableitungsstruktur (OS) und dem Lichtmodul (LM) bereitgestellt ist; und
einen Strömungsgenerator (310b), der dem äußeren Wärmeaustauschabschnitt (322) entspricht,
wobei ein Umgebungsluftstrom (AF) in die Lage versetzt wird, durch die äußere Wärmeableitungsstruktur (OS) hindurch zu strömen.

2. Wärmetauscher nach Anspruch 1, wobei die äußere Wärmeableitungsstruktur (OS) mindestens einen äußeren Wärmeableitungskanal (3221) beinhaltet und der Umgebungsluftstrom (AF) in die Lage versetzt wird, durch den mindestens einen äußeren Wärmeableitungskanal (3221) hindurch zu strömen.

3. Wärmetauscher nach Anspruch 1 oder 2, wobei die äußere Wärmeableitungsstruktur (OS) eine Vielzahl von Kühlrippen (F1) umfasst und der Umgebungsluftstrom (AF) in die Lage versetzt wird, durch die Vielzahl von Kühlrippen (F1) hindurch zu strömen.

4. Wärmetauscher nach Anspruch 2 oder 3, wobei der innere Wärmeaustauschabschnitt (321) ferner eine Innenseitenfläche (3212) beinhaltet, die dem Lichtmodul (LM) zugewandt ist, der äußere Wärmeaustauschabschnitt (322) ferner eine Außenseitenfläche (3222) beinhaltet, die der Innenseitenfläche (3212) gegenüberliegt, und der mindestens eine innere Wärmeableitungskanal (3211) und der mindestens eine äußere Wärmeableitungskanal (3221) zwischen der Innenseitenfläche (3212) und der Außenseitenfläche (3222) liegen.

5. Wärmetauscher nach einem der Ansprüche 2 bis 4, wobei sowohl eine Anzahl des mindestens einen inneren Wärmeableitungskanals (3211) als auch eine Anzahl des mindestens einen äußeren Wärmeableitungskanals (3221) ein Vielfaches sind, wobei eine Summe von Querschnittsflächen der inneren Wärmeableitungskanäle (3211) und der äußeren Wärmeableitungskanäle (3221) 35 % bis 70 % einer Summe von Querschnittsflächen des inneren Wärmeaustauschabschnitts (321) und des äußeren Wärmeaustauschabschnitts (322) beträgt.

6. Wärmetauscher nach einem der Ansprüche 2 bis 5, ferner umfassend eine Vielzahl von Kühlrippen (F1), die in mindestens einem des mindestens einen inneren Wärmeableitungskanals (3211) und des mindestens einen äußeren Wärmeableitungskanals angeordnet sind.

7. Wärmetauscher nach Anspruch 1, wobei die elektronische Vorrichtung (ED) eine Anzeigevorrichtung (1) beinhaltet, das Lichtmodul ein Hintergrundlichtmodul (220) der Anzeigevorrichtung (1) beinhaltet, wobei die Anzeigevorrichtung (1) Folgendes umfasst:
ein Gehäuse (10), umfassend einen Anzeigeabschnitt (110) und einen hinteren Abschnitt (120), die einander gegenüberliegen;
eine Abdeckung (212), die auf dem Gehäuse (10) angeordnet ist; und
eine Anzeigebaugruppe (20), umfassend eine Anzeigeeinheit (210) und das Hintergrundlichtmodul (220), wobei die Anzeigeeinheit (210) durch den Anzeigeabschnitt (110) nach außen freigelegt wird;
einen ersten Strömungsgenerator (310a), der in dem Gehäuse (10) angeordnet ist;
den Strömungsgenerator (310b), der auf der Abdeckung (212) angeordnet ist; und
den Wärmetauscher (320), der auf dem hinteren Abschnitt (120) des Gehäuses (10) angeordnet ist, wobei
der innere Wärmeaustauschabschnitt (321) dazu konfiguriert ist, angrenzend an das Hintergrundlichtmodul (220) der Anzeigebaugruppe (20) angebracht zu werden,
das Hintergrundlichtmodul (220) in thermischem Kontakt mit dem inneren Wärmeaustauschabschnitt (321) steht,
der mindestens eine innere Wärmeableitungskanal (3211) mit einem Baugruppenraum (231) der Anzeigebaugruppe (20) verbunden ist,
der erste Strömungsgenerator (310a) dem mindestens einen inneren Wärmeableitungskanal (3211) entspricht und
der Hochtemperaturgasstrom (HF), der durch die Anzeigebaugruppe (20) erzeugt wird, in die Lage versetzt wird, durch den Baugruppenraum (20) und den mindestens einen inneren Wärmeableitungskanal (3211) hindurch zu strömen.

8. Wärmetauscher nach Anspruch 7, wobei der innere Wärmeaustauschabschnitt (321) ferner eine Innenseitenfläche (3212) beinhaltet, die der Anzeigebaugruppe (20) zugewandt ist.

9. Wärmetauscher nach einem der Ansprüche 7 und 8, wobei die Anzeigebaugruppe (20) ferner eine Kammer (230) umfasst, die Kammer (230) zwischen der Anzeigeeinheit (210) und dem Hintergrundlichtmodul (220) liegt und die Kammer (230) den Baugruppenraum (231) beinhaltet.

## Revendications

1. Échangeur de chaleur (320) pour un dispositif électronique (ED) comprenant un module de lumière (LM), l'échangeur de chaleur (320) **caractérisé en ce que** l'échangeur de chaleur (320) comprend :
une partie d'échange de chaleur interne (321) configurée pour être fixée de manière adjacente au module de lumière (LM), la partie d'échange de chaleur interne (321) incluant au moins un canal de dissipation de chaleur interne (3211), l'au moins un canal de dissipation de chaleur interne (3211) étant relié à un espace de dispositif (ES) du dispositif électronique (ED), dans lequel un flux de gaz à haute température (HF) généré par le dispositif électronique (ED) est autorisé à passer à travers l'espace de dispositif (ES) et l'au moins un canal de dissipation de chaleur interne (3211) ;
une partie d'échange de chaleur externe (322) en contact thermique avec la partie d'échange de chaleur interne (321), la partie d'échange de chaleur externe (322) incluant une structure de dissipation de chaleur externe (OS) non reliée à l'au moins un canal de dissipation de chaleur interne (3211), dans lequel l'au moins un canal de dissipation de chaleur interne (3211) est prévu entre la structure de dissipation de chaleur externe (OS) et le module de lumière (LM) ; et
un générateur de flux (310b) correspondant à la partie d'échange de chaleur externe (322),
dans lequel un flux d'air ambiant (AF) est autorisé à passer à travers la structure de dissipation de chaleur externe (OS).

2. Échangeur de chaleur selon la revendication 1, dans lequel la structure de dissipation de chaleur externe (OS) inclut au moins un canal de dissipation de chaleur externe (3221), et le flux d'air ambiant (AF) est autorisé à passer à travers l'au moins un canal de dissipation de chaleur externe (3221).

3. Échangeur de chaleur selon la revendication 1 ou 2, dans lequel la structure de dissipation de chaleur externe (OS) comprend une pluralité d'ailettes de dissipateur de chaleur (F1), et le flux d'air ambiant (AF) est autorisé à passer à travers la pluralité d'ailettes de dissipateur de chaleur (F1).

4. Échangeur de chaleur selon la revendication 2 ou 3, dans lequel la partie d'échange de chaleur interne (321) inclut en outre une surface latérale intérieure (3212) faisant face vers le module de lumière (LM), la partie d'échange de chaleur externe (322) inclut en outre une surface latérale extérieure (3222) opposée à la surface latérale intérieure (3212), l'au moins un canal de dissipation de chaleur interne (3211) et l'au moins un canal de dissipation de chaleur externe (3221) sont situés entre la surface latérale intérieure (3212) et la surface latérale extérieure (3222).

5. Échangeur de chaleur selon l'une quelconque des revendications 2 à 4, dans lequel à la fois un nombre de l'au moins un canal de dissipation de chaleur interne (3211) et un nombre de l'au moins un canal de dissipation de chaleur externe (3221) sont multiples, dans lequel une somme des surfaces de section transversale des canaux de dissipation de chaleur internes (3211) et des canaux de dissipation de chaleur externes (3221) est de 35 % à 70 % d'une somme des surfaces de section transversale de la partie d'échange de chaleur interne (321) et de la partie d'échange de chaleur externe (322).

6. Échangeur de chaleur selon l'une quelconque des revendications 2 à 5, comprenant en outre une pluralité d'ailettes de dissipateur de chaleur (F1) disposées dans au moins un parmi l'au moins un canal de dissipation de chaleur interne (3211) et l'au moins un canal de dissipation de chaleur externe.

7. Échangeur de chaleur selon la revendication 1, dans lequel le dispositif électronique (ED) inclut un dispositif d'affichage (1), le module de lumière inclut un module de rétroéclairage (220) du dispositif d'affichage (1), dans lequel le dispositif d'affichage (1) comprend :
un boîtier (10) comprenant une partie d'affichage (110) et une partie arrière (120) opposées l'une à l'autre ;
un couvercle (212) disposé sur le boîtier (10) ; et
un ensemble d'affichage (20) comprenant une unité d'affichage (210) et le module de rétroéclairage (220), dans lequel l'unité d'affichage (210) est exposée à l'extérieur par la partie d'affichage (110) ;
un premier générateur de flux (310a) disposé dans le boîtier (10) ;
le générateur de flux (310b) disposé sur le couvercle (212) ; et
l'échangeur de chaleur (320) disposé sur la partie arrière (120) du boîtier (10),
la partie d'échange de chaleur interne (321) est configurée pour être fixée de manière adjacente au module de rétroéclairage (220) de l'ensemble d'affichage (20),
le module de rétroéclairage (220) est en contact thermique avec la partie d'échange de chaleur interne (321),
l'au moins un canal de dissipation de chaleur interne (3211) est relié à un espace d'assemblage (231) de l'ensemble d'affichage (20),
le premier générateur de flux (310a) correspond à l'au moins un canal de dissipation de chaleur interne (3211), et
le flux de gaz à haute température (HF) généré par l'ensemble d'affichage (20) est autorisé à passer à travers l'espace d'assemblage (20) et l'au moins un canal de dissipation de chaleur interne (3211).

8. Échangeur de chaleur selon la revendication 7, dans lequel la partie d'échange de chaleur interne (321) inclut en outre une surface latérale intérieure (3212) faisant face vers l'ensemble d'affichage (20).

9. Échangeur de chaleur selon l'une quelconque des revendications 7 et 8, dans lequel l'ensemble d'affichage (20) comprend en outre une chambre (230), la chambre (230) est située entre l'unité d'affichage (210) et le module de rétroéclairage (220), et la chambre (230) inclut l'espace d'assemblage (231).
